(19) Europäisches Patentamt

European Patent Office

Office européen des brevets

(11) **EP 0 838 856 A2**

(12) **EUROPÄISCHE PATENTANMELDUNG**

(43) Veröffentlichungstag:
**29.04.1998 Patentblatt 1998/18**

(51) Int. Cl.⁶: **H01L 27/02**

(21) Anmeldenummer: **97114966.1**

(22) Anmeldetag: **29.08.1997**

(84) Benannte Vertragsstaaten:
**AT BE CH DE DK ES FI FR GB GR IE IT LI LU MC NL PT SE**
Benannte Erstreckungsstaaten:
**AL LT LV RO SI**

(30) Priorität: **24.10.1996 DE 19644193**

(71) Anmelder: **ROBERT BOSCH GMBH**
**70442 Stuttgart (DE)**

(72) Erfinder:
• **Schirmer, Guenter**
  **72768 Reutlingen (DE)**
• **Werner, Frank**
  **72805 Lichtenstein (DE)**
• **Raub, Hans**
  **72760 Reutlingen (DE)**

(54) **Integrierte Überlastschutzeinrichtung**

(57) Es wird eine Überlastschutzeinrichtung für integrierte Bauelemente vorgeschlagen, die schnell auf kurzzeitig auftretende lokale Temperaturerhöhungen anspricht, um das betreffende Bauelement gegen Überlastung, bzw. Überhitzung, zu schützen. Die Schutzeinrichtung umfaßt einen ohmschen Meßwiderstand aus Metall, insbesondere Aluminium, der integriert auf dem Bauelement angeordnet ist. Temperaturerhöhungen bzw. auftretende Verlustleitungen in einzelnen Transistorzellen können so zuverlässig registriert werden.

FIG.1

**Beschreibung**

Stand der Technik

Die Erfindung geht aus von einer integrierten Überlastschutzeinrichtung nach der Gattung des Hauptanspruchs. Aus dem Artikel „Schutz von Leistungshalbleitern bei der Ansteuerung externer Lasten" von F.P. Zantis in der Zeitschrift „Elektor", 4/93, S. 41 bis 48, ist schon eine Überlastschutzeinrichtung mit einem ohmschen Widerstand als Temperatursensor bekannt, bei der aber die enge Kopplung des Temperatursensors mit dem zu schützenden Leistungstransistor lediglich darin besteht, daß beide auf einem gemeinsamen Kühlkörper montiert sind.

Vorteile der Erfindung

Die erfindungsgemäße Schutzeinrichtung mit den kennzeichnenden Merkmalen des Hauptanspruchs hat demgegenüber den Vorteil, einen Schutz von beispielsweise Leistungstransistoren vor thermischer Zerstörung mit verbesserter Zuverlässigkeit zu gewährleisten. Anormale Temperaturanstiege werden mit verbesserter Empfindlichkeit registriert, gleichzeitig ist der Temperatursensor elektrisch von dem zu schützenden Bauelement isoliert. Er ist also gleichzeitig insbesondere vor etwaigen negativen Substratspannungen geschützt.

Durch die in den abhängigen Ansprüchen aufgeführten Maßnahmen sind vorteilhafte Weiterbildungen und Verbesserungen der im Hauptanspruch angegebenen integrierten Überlastschutzeinrichtung möglich.

Bei der Ausbildung des Meßwiderstands als Metallstreifen ist in vorteilhafter Weise eine großflächige laterale Abdeckung des zu schützenden integrierten Bauelements mit dem Temperatursensor möglich.

Insbesondere wenn der Meßwiderstand in einem Abstand von weniger als 5 Mikrometer vom thermisch belasteten Halbleitergebiet angeordnet ist, wird es möglich, kurzzeitig auftretende, sehr hohe Verlustleistungen, die zu lokal hohen Erwärmungen im Mikrosekundenbereich führen, zuverlässig zu registrieren und entsprechend eine Bauelementzerstörung zu verhindern.

Eine mäanderförmige Anordnung des Meßwiderstands um Anreihungen von Transistorzellen erfaßt in besonders geeigneter Weise lokal aufgelöst mögliche anormale Temperaturanstiege.

Eine Anordnung des Meßwiderstands zwischen der Gateschicht eines MOS-Leistungstransistors und einer darüberliegenden Metallage, die als gemeinsamer Sourceanschluß dient, führt zu einem innigen Wärmekontakt des Meßwiderstands mit dem thermisch belasteten Halbleitergebiet jenseits jeglicher Wärmeabflußmöglichkeiten über großflächige Anschlußkontakte.

Eine zugehörige Auswerteschaltung mit einem Referenzwiderstand, der den gleichen Fertigungstoleranzen unterworfen ist wie der Meßwiderstand, führt zu einer Verringerung des Einflusses von Fertigungstoleranzen in der Festlegung einer Abschaltschwelle.

Desweiteren ist es mit einer sehr einfachen Schaltungsanordnung möglich, relative Temperaturänderungen, insbesondere kurzzeitige hohe Verlustleistungen, weitgehend unabhängig von Fertigungstoleranzen zu registrieren.

Eine etwas verbesserte Auswerteschaltung ermöglicht nicht nur eine einfache und zuverlässige Registrierung kurzzeitig auftretender relativer Temperaturänderungen, sondern gestattet es außerdem, die Temperatur in einfacher Weise absolut zu messen. Durch diese Verbesserung der Auswerteschaltung wird der Nachteil eines notwendigen Chipabgleichs, insbesondere ein sonst notwendiger Abgleich von Stromquellen, vermieden. Unabhängig von Fertigungstoleranzen ist die absolute Temperatur bestimmbar, d.h. auch für statische Erwärmungen des gesamten Bauelements oder des gesamten Chips ist ein Abschalten mit der erfindungsgemäßen Schutzeinrichtung vornehmbar.

Diese verbesserte Auswerteschaltung weist einen Schaltungsteil auf, der einen temperaturunabhängigen, aber vom Referenzwiderstand abhängigen Strom liefert. In vorteilhafter Weise kann dieser Schaltungsteil als Ringstromquelle ausgeführt werden. Ein Vorteil der Ringstromquelle ist, daß geeignete Stromwerte bei den verwendeten kleinen Werten der Metallwiderstände für Referenz- und Meßwiderstand von wenigen hundert Ohm und bei nur sehr kleinen Spannungen von unter hundert Millivolt gewonnen werden können, die sich mit einer Ringstromquelle einfach über die Emitterzahl des Ausgangstransistors einstellen lassen.

Zeichnung

Ausführungsbeispiele der Erfindung sind in der Zeichnung dargestellt und in der nachfolgenden Beschreibung näher erläutert. Es zeigen

Figur 1 eine Draufsicht auf einen MOS-Leistungstransistor mit integriertem Meßwiderstand aus Aluminium,
Figur 2 eine perspektivische Ansicht des MOS-Leistungstransistors aus Figur 1,
Figur 3 eine zugehörige Auswerteschaltung,
Figur 4 eine Prinzipskizze einer verbesserten Auswerteschaltung,
Figur 5 eine einfache Realisierung einer verbesserten Auswerteschaltung nach Figur 4 und
Figur 6 eine Stromspiegelbank, wie sie in der Schaltung nach Figur 5 verwendet wird.

Beschreibung der Ausführungsbeispiele

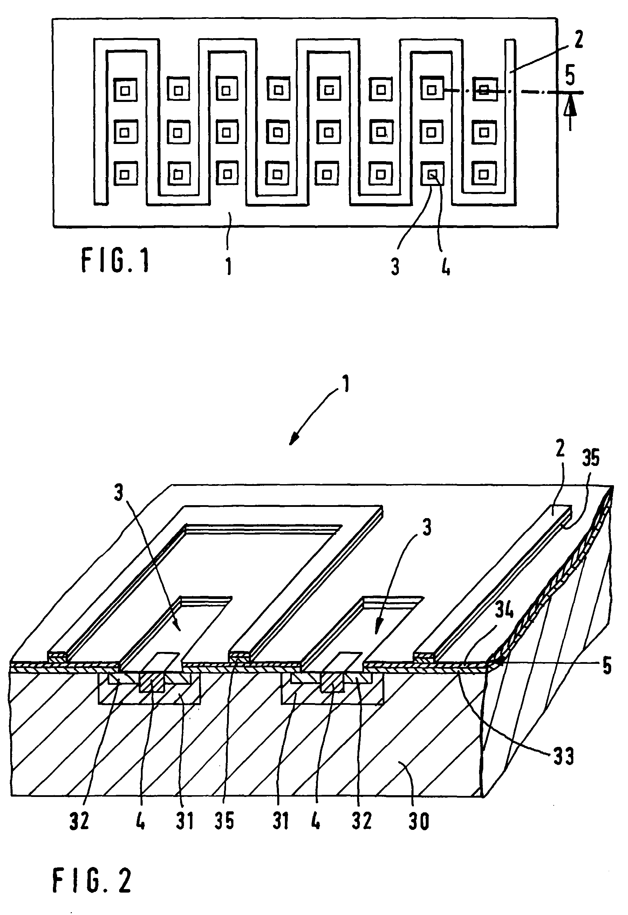

Figur 1 zeigt in einer Draufsicht einen MOS-Transistor 1 mit einer Vielzahl von Transistorzellen 3, in denen jeweils das zugehörige Sourcegebiet 4 eingezeichnet ist. Die Kontaktierung der einzelnen Sourcegebiete und sonstige Kontaktierungen des MOS-Transistors sind in der Zeichnung weggelassen. Ein Aluminiumstreifen 2 windet sich mäanderförmig um die einzelnen Reihen der Transistorzellen. Eine Schnittlinie 5 zeigt die Richtung an, entlang der in Figur 2 ein Querschnitt durch den Leistungstransistor ersichtlich ist. In Figur 1 wie in Figur 2 sind das Draingebiet sowie dazugehörige Anschlußkontakte der Einfachheit halber in der Zeichnung weggelassen. Insbesondere ist auch eine obere Metallage, die elektrisch isoliert vom Aluminiumstreifen 2 aufgetragen ist und zur Kontaktierung der Sourcegebiete dient, nicht dargestellt. Die Mäanderform des Aluminiumstreifens gewährleistet einen innigen Wärmekontakt zu den einzelnen Transistorzellen und somit eine schnelle Reaktion auf lokale anormale Temperaturerhöhungen.

Figur 2 zeigt einen perspektivisch dargestellten Querschnitt des in Figur 1 in Draufsicht dargestellten Leistungstransistors mit integriertem Aluminiumstreifen. In ein n-dotiertes Halbleitergebiet 30 sind p-dotierte Wannen 31 eingebettet, in die wiederum jeweils das dazugehörige Sourcegebiet 4 eingebettet ist. Das Sourcegebiet 4 ist dabei von stark n-dotierten Bereichen 32 umgeben. Auf die Oberfläche des Halbleitergebiets 30 ist eine Gateoxidschicht 33 aufgetragen, auf die wiederum eine Polysiliziumgateschicht 34 abgeschieden ist. Die Sourcegebiete der einzelnen Transistorzellen 3 sind dabei weder von der Gateoxidschicht 33, noch von der Polysiliziumgateschicht 34 bedeckt. Auf der Polysiliziumgateschicht 34 befindet sich der Aluminiumstreifen 2, der sich mäanderförmig um die einzelnen Reihen der Transistorzellen 3 windet. Dabei ist der Aluminiumstreifen 2 von der Polysiliziumgateschicht 34 durch eine Zwischenoxidschicht 35 isoliert. Die Zwischenoxidschicht weist typischerweise eine Dicke von zirka einem Mikrometer auf. Der Abstand des als Aluminiumstreifen 2 ausgebildeten Meßwiderstands zum oberflächennahen, thermisch belasteten Teil des Halbleitergebiet 30 beträgt weniger als 5 Mikrometer, so daß eine optimale thermische Kopplung gegeben ist. Oberhalb des Aluminiumstreifens 2 ist elektrisch isoliert von diesem eine obere Metallage angeordnet, die als gemeinsamer Sourceanschluß für alle Transistorzellen des Leistungstransistors dient. Diese obere Metallage ist Figur 2 nicht eingezeichnet. Die Kontaktierung der einzelnen Sourcegebiete 4 zur oberen Metallage geschieht über lokal begrenzte Metallisierungen, die über Durchkontaktierungen elektrisch mit der oberen Metallage verbunden sind. Die genaue Ausführungsform der Kontaktierung der einzelnen Sourcegebiete kann im einzelnen variieren. Wesentlich ist lediglich, daß sich der Aluminiumstreifen 2 so nah wie möglich am thermisch belasteten Halbleitergebiet 30 befindet. Dies ist gegeben, wenn der gemeinsame Sourceanschluß aller Transistorzellen, vom Halbleitergebiet 30 aus betrachtet, sich jenseits des Aluminiumsstreifens 2 befindet.

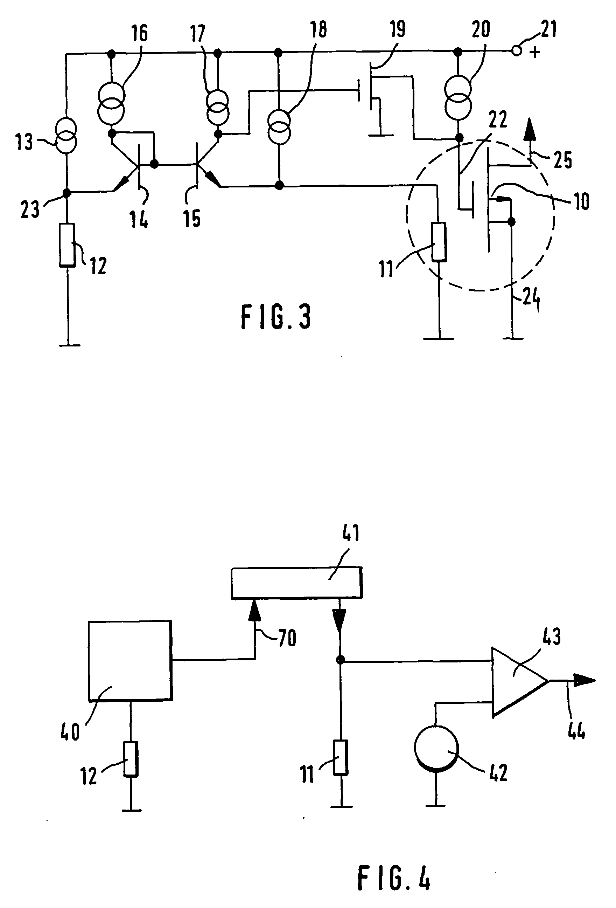

Figur 3 zeigt eine zum als Meßwiderstand 11 verwendeten Aluminiumstreifen 2 zugehörige Auswerteschaltung. Eine Referenzstromquelle 13 speist in einem Referenzwiderstand 12 einen Strom ein. Ein als Transistordiode geschalteter Referenztransistor 14 und ein Steuertransistor 15 sind zusammen mit einer Transistordiodenstromquelle 16 als Stromspiegel geschaltet. Der Kollektor des Steuertransistors 15 ist über eine Steuerstromquelle 17 mit dem Pluspol 21 einer Spannungsversorgung verbunden. Ebenso ist die Referenzstromquelle 13 und die Transistordiodenstromquelle 16 an dem Pluspol der Spannungsversorgung angeschlossen. Der Emitter des Referenztransistors 14 ist an einem Knoten 23 zwischen der Referenzstromquelle 13 und dem Referenzwiderstand 12 angeschlossen, so daß die am Referenzwiderstand 12 abfallende Spannung das Potential des Emitters des Referenztransistors 14 festlegt. Zur Steuerstromquelle 17 und zur Kollektor-Emitter-Strecke des Steuertransistors 15 parallelgeschaltet ist eine Meßstromquelle 18. Der Emitter des Steuertransistors 15 ist über den Meßwiderstand 11, der sich in unmittelbarer Nähe des thermisch belasteten Halbleitergebietes 30 befindet, mit einem Masseanschluß verbunden, ebenso ist der Emitter des Referenztransistors 14 über den Referenzwiderstand 12 mit Masse verbunden ist. Ein Abschalttransistor 19 wird mit dem Kollektorpotential des Steuertransistors 15 angesteuert. Der Abschalttransistor 19 ist zum einen mit Masse zum anderen mit dem Steuereingang (Gate) des zu schützenden Leistungstransistors, insbesondere DMOS-Transistors 10, verbunden. Eine durch die Anwendung des Transistors 10 gegebene Ansteuerung desselben ist durch eine Stromquelle 20 symbolisiert, die mit dem einen Anschluß am Pluspol 21 der Spannungsversorgung liegt. Die weitere Verdrahtung des Transistors 10 über seine weiteren Anschlüsse 24 und 25 ist durch die jeweilige Anwendung vorgegeben.

Der Stromspiegel, bestehend aus Transistordiodenstromquelle 16, Referenztransistor 14 und Steuertransistor 15, bildet zusammen mit der Steuerstromquelle 17 einen Komparator. Der Komparator vergleicht die am Referenzwiderstand 12 abfallende Spannung mit der am Meßwiderstand 11 abfallenden Spannung. Der von der Steuerstromquelle 17 und der Transistordiodenstromquelle 16 gelieferte Strom ist klein im Vergleich zum Strom der Referenzstromquelle 13 und klein im Vergleich zum Strom der Meßstromquelle 18. Daher werden die Spannungen, die am Referenzwiderstand 12 bzw. am Meßwiderstand 11 abfallen, im wesentlichen vom Strom der Referenzstromquelle 13, bzw. vom Strom der Meßstromquelle 18 festgelegt. Durch geeignete Wahl der Widerstandswerte von Referenzwiderstand 12 und Meßwiderstand 11 sowie durch geeignete Wahl der Stromquellen 13 und 18 wird festgelegt, daß im Normalbetrieb die am Meßwiderstand 11 abfallende Spannung kleiner ist als die am Referenzwiderstand 12 abfallende. In diesem Zustand ist das Gate des Abschalttransistors 19 entladen, der Abschalttransistor 19 sperrt also. Erhöht sich nun die Temperatur des Transistors 10 über einen kritischen Wert, der durch die exakte Wahl der Widerstandswerte, bzw. Stromwerte der verwendeten Stromquellen festgelegt ist, so überschreitet der Spannungsabfall am Meßwiderstand 11 den Spannungsabfall am Widerstand 12. So wird das Gate des Abschalttransistors positiv aufgeladen. Dadurch schaltet der Abschalttransistor 19 in den leitenden Zustand und schließt die Ansteuerung 20 des Leistungstransistors 10 mit der Masse kurz und schaltet auf diese Weise den über die Anschlüsse 24 und 25 fließenden Laststrom ab, der die unerwünschte Überhitzung verursacht hat. Der Vorteil dieser Schaltung im Zusammenhang mit dem Meßwiderstand 11, wie er als Ausführungsbeispiel in den Figuren 1 und 2 beschrieben ist, liegt in dem sicheren Nachweis schneller lokaler Temperaturanstiege aufgrund von Strömen, die kurzzeitig 5 bis 10 Ampere betragen können, innerhalb eines Zeitraumes von nur 5 bis 10 Mikrosekunden können sich Temperaturanstiege um 300 Kelvin ergeben. Der Widerstand des Aluminiumstreifens weist dabei typischerweise Werte in der Größenordnung von 200 Ohm auf. Die Transistordiodenstromquelle 16 sowie die Steuerstromquelle 17 liefern Ströme in der Größenordnung von 10 Mikroampere. Der Referenzstrom, gegeben durch die Referenzstromquelle 13, ist ca. zehn mal größer als der Strom der Transistordiodenstromquelle 16, bzw. der Steuerstromquelle 17. Der Referenzwiderstand 12 und der Meßwiderstand 11 bestehen beide aus dem gleichen Material (Aluminium) und werden im gleichen Herstellungsschritt aufgetragen. Somit unterliegen beide den gleichen Fertigungstoleranzen. Wählt man für den Referenzwiderstand den gleichen Widerstandswert wie für den Meßwiderstand, so muß die Meßstromquelle 18 einen kleineren Strom liefern als die Referenzstromquelle 13, um die oben beschriebene Funktionsweise zu gewährleisten.

Durch die beschriebene Auswerteschaltung ist zwar eine Verringerung des Einflusses von Fertigungstoleranzen auf die Schaltschwelle gegeben, aber sie ist nicht völlig unterbunden, denn nur bei exakt gleichen Widerstandswerten von Referenzwiderstand und Meßwiderstand sowie exakt gleichen Stromwerten von Referenzstromquelle 13 und Meßstromquelle 18 wirken sich Fertigungstoleranzen von Referenz- und Meßwiderstand nicht aus, auch wenn in jedem Falle gewährleistet ist, daß Referenz- und Meßwiderstand mit der gleichen Fertigungsstreuung behaftet sind. Unterscheiden sich beispielsweise der Referenzwiderstand 12 und der Meßwiderstand 11 in ihren Widerstandswerten voneinander, so wirkt eine Temperaturänderung eine unterschiedlich große Änderung des Spannungsabfalls am jeweiligen Widerstand, auch wenn die beiden Widerstände prozentual mit der gleichen Fertigungsstreuung behaftet sind. Das ist zwar uninteressant, wenn nur relative Temperaturänderungen innerhalb kurzer Zeiten, die sehr hoch sind, detektiert werden sollen. In solchen Fällen ist es auch unerheblich, wenn der Referenzwiderstand 12, auch wenn er entfernt vom thermisch belasteten Halbleitergebiet 30 angeordnet ist, sich etwas erwärmt. Soll jedoch die Schutzeinrichtung nicht nur schnell auf relative lokale Temperaturänderungen reagieren, sondern auch auf eine statische Erwärmung des gesamten Halbleiterbauelements, so muß der Wert des Referenzwiderstands gleich groß gewählt werden, wie der Wert des Meßwiderstands. Auch die Stromwerte von Referenzstromquelle 13 und Meßstromquelle 18 müssen gleich groß sein. Als Ausweg ist dann ein Vorhaltewiderstand zwischen dem Knoten 23 und dem Emitter des Referenztransistors 14 erforderlich, der gewährleistet, daß im Normalbetrieb die am Meßwiderstand 11 abfallende Spannung kleiner ist als die Summe der Spannungsabfälle, die am Vorhaltewiderstand und am Referenzwiderstand auftreten. Denn in dieser Ausführungsvariante der Auswerteschaltung ist dann diese Summe die relevante Bezugsspannung für eine Schaltschwelle zum Abschalten des Leistungstransistors bei Überhitzung. Damit keine Fertigungstoleranzen bzgl. der Abschaltschwelle auftreten können, muß der Vorhaltewiderstand aus dem gleichen Material wie der Referenz- und der Meßwiderstand gefertigt sein. Bei Aluminium, wie im Ausführungsbeispiel in Figur 1 und 2 als bevorzugte Ausführungsform dargestellt, bedeutet dies einen erheblichen Platzbedarf. Dieser Platzbedarf kann durch eine verbesserte Auswerteschaltung umgangen werden, wie sie in Figur 4 bis 6 beschrieben ist. Ein weiterer möglicher Nachteil der Schaltung gemäß Figur 3 ist ihre Schwinganfälligkeit. Diese Schwinganfälligkeit ist aber in vielen Anwendungen unbedeutend und falls sie doch bedeutend sein sollte, kennt der Fachmann Maßnahmen zu ihrer Behebung, beispielsweise den Einbau von Zeitverzögerungsgliedern.

Figur 4 zeigt den Prinzipaufbau einer verbesserten Ausführungsform der Auswerteschaltung mit einem $I_{TK0}$-Schaltungsteil 40, der über dem Referenzwiderstand 12 auf Masse liegt. Der $I_{TK0}$-Schaltungsteil 40 ist mit dem Bankeingang einer Stromspiegelbank 41 verbunden. Der mindestens eine Ausgang der Stromspiegelbank 41 liegt über dem Meßwiderstand 11 auf Masse. Die am Meßwiderstand 11 abfallende Spannung ist auf den einen Eingang eines Komparators 43 geführt. Der zweite Eingang des Komparators 43 ist mit der Bezugsspannung aus einem $U_V$-Schaltungsteil belegt. Das Ausgangssignal 44 des Komparators wird zur Ansteuerung des Abschalttransistors verwendet.

Der Schaltungsteil 40 erzeugt einen temperaturunabhängigen Strom, dessen Größe mit der prozeßbedingten Streuung (+/-20%) des aus Aluminium gefertigten Referenzwiderstands 12 schwankt, der Strom ist umgekehrt proportional zum Widerstandswert des Referenzwiderstands. Eine temperaturunabhängige Vergleichsspannung wird von einem Schaltungsteil 42 geliefert. Der vom Schaltungsteil 40 erzeugte Strom wird über die Stromspiegelbank 41 auf den Meßwiderstand 11 gespiegelt, dessen Wert ebenso wie der Wert des Referenzwiderstands schwankt. Die Meßspannung am Meßwiderstand 11 ist somit unabhängig von der Absolutstreuung der Metallwiderstände. Die am Meßwiderstand abfallende Spannung ist das Produkt eines zum vom Schaltungsteil 40 gelieferten temperaturunabhängigen Strom proportionalen Stroms mit dem temperaturabhängigen Widerstandswert des Meßwiderstands 11, mit anderen Worten: der Spannungsabfall am Meßwiderstand 11 ist proportional zum Quotienten des temperaturabhängigen Meßwiderstands mit dem Referenzwiderstand. Es besteht ein linearer Zusammenhang zwischen dem Meßwiderstand und der Temperatur und damit eine lineare Temperaturabhängigkeit der Meßspannung. Die Meßspannung wird im Komparator 43 mit der Bezugsspannung, die ebenfalls temperaturunabhängig von dem Schaltungsteil 42 geliefert wird, verglichen Bei Überschreitung des Wertes der Bezugsspannung liefert ein entsprechendes Ausgangssignal 44 des Komparators die notwendige Information an den Abschalttransistor, um die Ansteuerung des Leistungstransistors vom Leistungstransistor, der zu heiß geworden ist, zu entkoppeln.

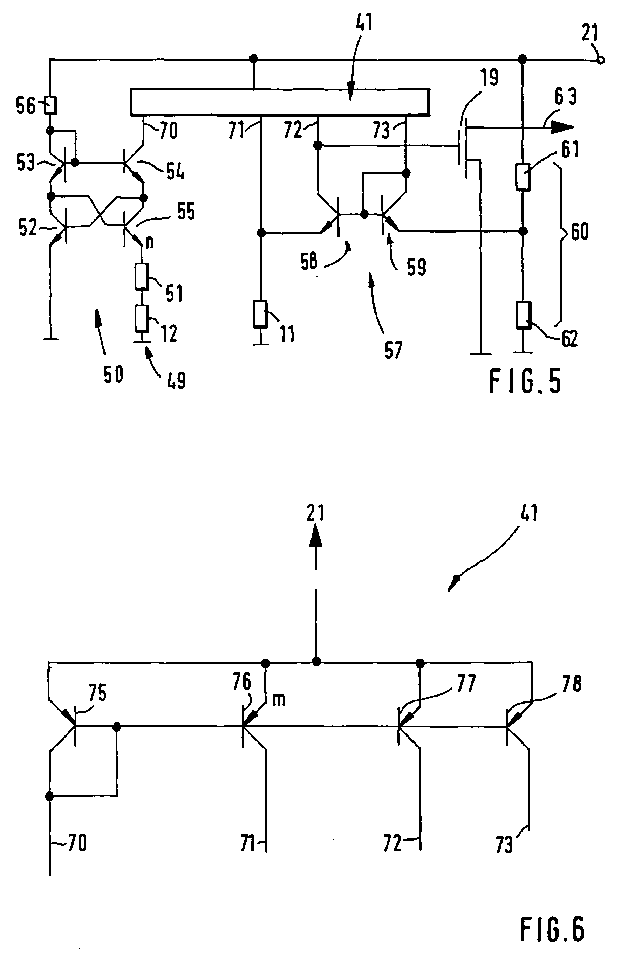

Figur 5 zeigt eine einfache Realisierung einer Auswerteschaltung nach dem Prinzip der Figur 4. Transistoren 52, 53, 54 und 55 sowie ein Widerstand 56 und der Referenzwiderstand 12 sowie ein Kompensationswiderstand 51, sind als Ringstromquelle 50 verschaltet. Der Ausgangstransistor 55 mit der Emitterzahl n liegt dabei über dem Kompensationswiderstand 51 und dem Referenzwiderstand 12 auf Masse. Transistor 54, Transistor 55 sowie Referenzwiderstand 12 und Kompensationswiderstand 51 stellen den Ausgangsstrompfad 49 der Ringstromquelle 50 dar. Der als Transistordiode verschaltete Transistor 53 liegt über dem Widerstand 56 am Pluspol 21 der Spannungsversorgung. Der Kollektor des Transistors 54 ist an dem Bankeingang 70 der Stromspiegelbank 41 angeschlossen, die ebenfalls mit dem Pluspol der Spannungsversorgung verbunden ist. Im gezeigten Ausführungsbeispiel besitzt die Stromspiegelbank 41 drei Bankausgänge 71, 72 und 73. Der Ausgang 71 ist mit dem Meßwiderstand 11 mit der Masse verbunden. Die Bankausgänge 72 und 73 sind mit den Kollektoren der als Stromspiegel 57 geschalteten Transistoren 58 und 59 verbunden. Der Emitter des Transistors 58 greift das Potential am Meßwiderstand 11 ab. Der Emitter des als Transistordiode geschalteten Transistors 59 liegt auf einem Bezugspotential, das durch einen linearen Spannungsteiler 60, der Spannungsteilerwiderstände 61 und 62 aufweist, gegeben ist. Der Kollektor des Transistors 58 ist mit dem Gate des Abschalttransistors 19 verbunden. Der Abschalttransistorausgang 63 ist wie in Figur 3 bereits dargestellt verschaltet. Die Ausgestaltung der Stromspiegelbank 41 ist in Figur 6 dargestellt. Die Stromspiegelbank ist eine erweiterte Stromspiegelschaltung mit drei Bankausgängen 71, 72 und 73. Der Bankeingang 70 ist gegeben durch den Kollektoranschluß des als Transistordiode geschalteten Banktransistors 75. Die weiteren Banktransistoren 76, 77 und 78 sind mit ihrem Basis-Emitter-Übergängen zum Basis-Emitter-Übergang des Banktransistors 75 parallel geschaltet, wobei der Banktransistor 76 eine Emitterzahl m aufweist; m liegt dabei typischerweise zwischen 1 und 10. In einer alternativen Ausführung mit MOSFET-Transistoren ist eine entsprechende Funktionsweise durch eine passende Wahl der Kanalweite des Transistors 76 relativ zur Kanalweite der restlichen Transistoren der Stromspiegelbank 41 gegeben. Durch die Emitterzahl m mit 1 < m ≤ 10 wird gewährleistet, daß der durch den Bankausgang 71 fließende Strom erheblich größer ist als der durch die Bankausgänge 72 und 73 fließende.

Die Ringstromquelle 50 entspricht dem Schaltungsteil 40, das in den Bankeingang 70 der Stromspiegelbank 41 einen temperaturunabhängigen Strom einspeist, der umgekehrt proportional zum Wert des Referenzwiderstands 12 ist. Über den Bankausgang 71 wird dieser temperaturunabhängige Strom in den Meßwiderstand 11 gespiegelt. Der an den Bankausgängen 72 und 73 angeschlossenen Stromspiegel 57 dient als Komparator 43 und vergleicht die am Meßwiderstand 11 abfallende Spannung mit der Bezugsspannung, die am Emitter des Transistors 59 anliegt und die von dem linearen Spannungsteiler 60 geliefert wird. Durch den linearen Spannungsteiler 60 wird die Schaltschwelle der Schutzeinrichtung eingestellt, und zwar temperaturunabhängig. Überschreitet die am Meßwiderstand 11 abfallende Spannung die Bezugsspannung, so wird der Abschalttransistor 19 analog wie in Figur 3 beschrieben, aktiv. Wie bereits beschrieben, wird durch diese Auswerteschaltung ein in Figur 3 eventuell erforderlicher Vorhaltewiderstand, der mit einem großen Flächenbedarf verbunden ist, vermieden. Ferner ist kein Chipabgleich mehr erforderlich. Es sind keine Stromquellen mehr vorhanden, die abgeglichen werden müßten. Der durch die Bankausgänge 72 und 73 fließende Strom ist klein im Vergleich zum Strom aus dem Bankausgang 71. Somit wird der Spannungsabfall am Referenzwiderstand 11 sowie am Spannungsteilerwiderstand 62 nur vom durch den Bankausgang 71 fließenden Strom, bzw. durch das Spannungsteilerverhältnis des Spannungsteilers 60 bestimmt. Durch diese Schaltung ist gewährleistet, daß die Meßspannung am Meßwiderstand 11 für eine gegebene Temperatur einen bestimmten konstanten Wert hat, unabhängig von Fertigungstoleranzen der Aluminiumwiderstände. Dadurch ist eine absolute Temperaturmessung möglich. Meßwiderstand sowie Referenzwiderstand bestehen aus Aluminium. Über die Zahl m der Emitter des Banktransistors 76 ist in einfacher Weise zusätzlich zur Wahl des Spannungsteilerverhältnisses des Spannungsteilers 60 die Schaltschwelle für die Schutzeinrichtung variierbar. Der Strom im Ausgangsstrompfad 49 der Ringstromquelle 50 berechnet sich als Produkt des Logarithmus der Emitterzahl n des Ausgangstransistors 55 mit dem Quotienten der thermischen Spannung mit der Summe von Referenz und Kompensationswiderstand. Die thermische Spannung ist gleich $\frac{k \cdot T}{e}$. Der

Kompensationswiderstand ist klein gewählt im Vergleich zum Referenzwiderstand und weist einen kleineren Temperaturkoeffizienten als der Referenzwiderstand auf. Daher ergibt sich als vorteilhafte Materialwahl für den Kompensationswiderstand Polysilizium. Der Kompensationswiderstand dient dazu, die leichte Überkompensation der Temperaturabhängigkeit der thermischen Spannung durch die Temperaturabhängigkeit des Referenzwiderstands herabzusetzen. Dadurch, daß der Kompensationswiderstand einen kleineren Temperaturkoeffizienten als der Referenzwiderstand aufweist, senkt der Kompensationswiderstand den Temperaturkoeffizienten der Summe der Widerstände von Kompensations- und Referenzwiderstand ab im Vergleich zum Temperaturkoeffizienten des Referenzwiderstands. Dadurch nähert sich der Temperaturkoeffizient der Widerstandssumme von Kompensations- und Referenzwiderstand dem Temperaturkoeffizienten der thermischen Spannung an und der Strom im Ausgangsstrompfad der Ringstromquelle 50 ist für die Anwendung im hinreichenden Maße temperaturunabhängig gestaltbar.

Die in Figur 5 dargestellte Schutzeinrichtung stellt eine universell einsetzbare Schutzeinrichtung dar, die sowohl auf kurzzeitig lokal auftretende hohe Verlustleistungen, wie auch auf eine insgesamte Erwärmung des zu schützenden Halbleiterbauelements gleichermaßen anspricht und so das zu schützende Halbleiterbauelement gegen alle erdenklichen Überhitzungsvarianten schützt.

**Patentansprüche**

1. Überlastschutzeinrichtung mit einem als ohmschen Meßwiderstand (11) ausgebildeten Temperatursensor für ein integriertes Bauelement, dadurch gekennzeichnet, daß der Meßwiderstand in dem integrierten Bauelement elektrisch isoliert integriert ist.

2. Schutzeinrichtung nach Anspruch 1, dadurch gekennzeichnet, daß der Meßwiderstand aus einem Metallstreifen (2) besteht, der streifenförmig, insbesondere mäanderförmig, angeordnet ist.

3. Schutzeinrichtung nach Anspruch 1 oder 2, dadurch gekennzeichnet, daß der Meßwiderstand auf der Gateschicht (34) eines MOS-Leistungstransistors (1) angeordnet ist und von der Gateschicht (34) durch ein Zwischenoxid (35) isoliert ist, wobei der Meßwiderstand (11) mäanderförmig um Anreihungen von Transistorzellen (3) des MOS-Leistungstransistors (1) angeordnet ist.

4. Schutzeinrichtung nach einem der vorhergehenden Ansprüche, dadurch gekennzeichnet, daß der Meßwiderstand (11) einen Abstand zu einem thermisch belasteten Halbleitergebiet (30) aufweist, der weniger als 5 Mikrometer beträgt.

5. Schutzeinrichtung nach Anspruch 3, dadurch gekennzeichnet, daß der Meßwiderstand (11) zwischen der Gateschicht (34) und einer einen für alle Sourcegebiete (4) gemeinsamen Sourceanschluß darstellenden Metallage angeordnet ist.

6. Schutzeinrichtung nach einem der vorhergehenden Ansprüche, dadurch gekennzeichnet, daß ein Spannungsabfall am Meßwiderstand (11), der mit einer thermischen Belastung des integrierten Bauelements korreliert ist, in einer Auswerteschaltung mit einer Bezugsspannung vergleichbar ist und daß bei Erreichen des Werts der Bezugsspannung über einen Abschalttransistor (19) ein wärmeproduzierender Stromfluß durch das integrierte Bauelement abschaltbar ist, wobei die Auswerteschaltung einen Referenzwiderstand (12) aufweist, der als gemeinsamer Bestandteil mehrerer Auswerteschaltungen verwendbar ist, die jeweils einem integrierten Bauelement zugeordnet sind, und der mit der gleichen Fertigungsstreuung behaftet ist wie der Meßwiderstand (11).

7. Schutzeinrichtung nach Anspruch 6, dadurch gekennzeichnet, daß die Auswerteschaltung einen als Transistordiode betriebenen Referenztransistor (14) und einen Steuertransistor (15) enthält, die zusammen mit einer Transistordiodenstromquelle (16) einen Stromspiegel bilden, wobei zur Transistordiodenstromquelle und der Transistordiode eine Referenzstromquelle (13) parallelgeschaltet ist, wobei der Emitter der Transistordiode über den Referenzwiderstand (12) mit Masse verbunden und der Kollektor des Steuertransistors (15) über eine Steuerstromquelle (17) mit einem Pluspol (21) einer Spannungsquelle verbunden ist, wobei zur Steuerstromquelle und dem Steuertransistor eine Meßstromquelle (18) parallelgeschaltet ist, wobei der Emitter des Steuertransistors über den Meßwiderstand (11) mit Masse verbunden und der Kollektor des Steuertransistors (15) mit dem Gate des als n-Kanal MOSFET-Transistor ausgeführten Abschalttransistors (19) verbunden ist, wobei der Sourceanschluß des Abschalttransistors (19) auf Masse liegt, der Drainanschluß mit dem Steuereingang (22) des integrierten Bauelements verbunden ist, der über eine Ansteuerung (20) mit dem Pluspol (21) der Spannungsquelle verbunden ist.

8. Schutzeinrichtung nach Anspruch 6, dadurch gekennzeichnet, daß die Auswerteschaltung ein $I_{TKo}$-Schaltungsteil (40), eine Stromspiegelbank (41) mit einem Bankeingang (70) und mindestens einem Bankausgang (71) aufweist sowie einen Komparator (43), wobei der Bankeingang (70) der Stromspiegelbank (41) mit einem nahezu temperaturunabhängigen, zum Referenzwiderstand umgekehrt proportionalen Strom aus dem $I_{TKo}$-Schaltungsteil (40) versorgt ist, daß über den mindestens einen Bankausgang (71) dieser temperaturunabhängige Strom in einen Strompfad gespiegelt wird, an dem der Meßwiderstand (11) angeschlossen ist, daß die am Meßwiderstand (11) abfallende Spannung an einem Eingang des Komparators (43) anliegt, an dessen zweitem Eingang die Bezugsspannung anliegt, wobei mit dem Ausgangssignal (44) des Komparators (43) der Abschalttransistor (19) steuerbar ist.

9. Schutzeinrichtung nach Anspruch 8, dadurch gekennzeichnet, daß das $I_{TKo}$-Schaltungsteil (40) eine Ringstromquelle (50) aufweist, in derem Ausgangsstrompfad (49) der Referenzwiderstand (12) und ein Kompensationswiderstand (51) in Reihe geschaltet sind.

10. Schutzeinrichtung nach Anspruch 8 oder 9, dadurch gekennzeichnet, daß der Komparator (43) zwei als Stromspiegel verschaltete Transistoren (58, 59) aufweist, der an zwei weitere Bankausgänge (72,73) der Stromspiegelbank (41) angeschlossen ist.

11. Schutzeinrichtung nach Anspruch 8, 9 oder 10, dadurch gekennzeichnet, daß die Bezugsspannung durch einen linearen Spannungsteiler (60) festgelegt ist.

12. Schutzeinrichtung nach einem der Ansprüche 6 bis 11, dadurch gekennzeichnet, daß die Auswerteschaltung auf dem integrierten Bauelement integriert ist.

13. Schutzeinrichtung nach einem der vorhergehenden Ansprüche, dadurch gekennzeichnet, daß das integrierte Bauelement ein DMOS-Leistungstransistor ist.

14. Schutzeinrichtung nach einem der vorhergehenden Ansprüche, dadurch gekennzeichnet, daß der Meßwiderstand (11) aus Aluminium besteht.

FIG.1

FIG. 2

FIG. 3

FIG. 4

FIG.5

FIG.6